# EUROPEAN PATENT APPLICATION

(11) **EP 4 597 214 A1**
(43) Date of publication of application: **06.08.2025**
(21) Application number: 22961508.3
(22) Date of filing: 05.10.2022
(51) Int. Cl.: G02F 1/166, G02F 1/137, G02F 1/1335, G02F 1/15

(54) **DISPLAY DEVICE**

(71) Applicant: LG Electronics Inc., Yeongdeungpo-gu Seoul 07336 (KR)
(72) Inventor: WOO, Guido, Seoul 06772 (KR); AN, Jungnam, Seoul 06772 (KR)
(74) Representative: Frenkel, Matthias Alexander
(86) International application number: PCT/KR2022/014965
(87) International publication number: WO 2024/075863

(57) **Abstract**

This display device comprises a first panel, comprising a plurality of pixels each comprising a light-emitting area and a light-transmitting area for transparent display, and a second panel, comprising cell areas corresponding respectively to the plurality of pixels in the first panel to control the light blocked to the first panel. The cell area of the second panel comprises a light-blocking control unit. The light-blocking control unit comprises: a first light-blocking control area that vertically overlaps the light-transmitting area and comprises at least one first transparent electrode; a second light-blocking control area that horizontally contacts the first light-blocking control area, vertically overlaps the light-emitting area, and comprises at least one second transparent electrode; and light-blocking particles that are charged to a first polarity and are dispersed in a space shared by the first light-blocking control area and the second light-blocking control area.

## Description

### [Technical Field]

An embodiment relates to a display device.

### [Background Art]

In recent years, there has been a rapid increase in demand for transparent display devices that allow users to view objects not only on the display panel but also behind the display panel.

Meanwhile, in transparent display devices, since light is transmitted to the user through the display panel, there was a problem of reducing the contrast ratio because it was difficult to implement complete black.

Schemes have been proposed to improve this contrast ratio.

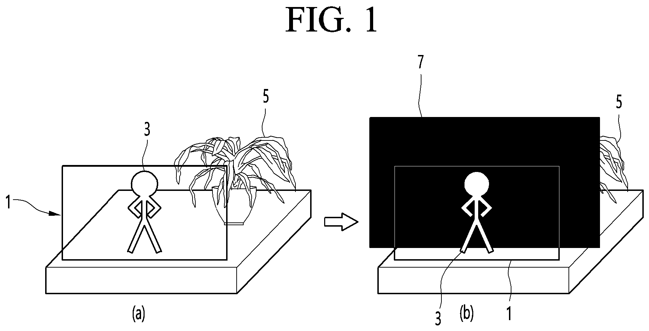

FIG. 1 illustrates a conventional transparent display having a black screen.

As illustrated in FIG. 1, a black screen 7 that can be selectively positioned at the rear of the display panel 1 is provided, so that light is prevented from passing through the display panel 1 by the black screen 7, thereby improving the contrast ratio.

If it is desired to clearly view the image object 3 on the display panel 1, a black screen 7 is positioned behind the display panel 1, and if it is desired to view the image object 3 on the display panel 1 and an external object 5 behind the display panel 1, the black screen 7 behind the display panel 1 is removed.

However, there was a problem that the black screen 7 could not respond quickly when the movement of moving to the rear of the display panel 1 and then returning to the original position was frequently performed. In addition, there was a problem that the black screen 7 became thick as a physical product.

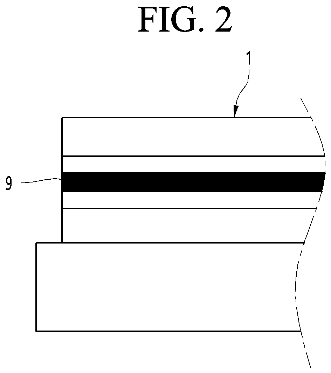

FIG. 2 illustrates a conventional transparent display having an electrochromic layer.

As illustrated in FIG. 2, an electrochromic layer 9 capable of adjusting transmittance is provided on the display panel 1, and the desired contrast ratio is implemented by adjusting the transmittance through the operation of the electrochromic layer 9.

However, there are still many difficulties in selecting the material or physical configuration of the electrochromic layer 9, and in particular, there was a problem of difficulty in implementing it for large displays such as TVs.

### [Disclosure]

### [Technical Problem]

An object of an embodiment of the present disclosure is to solve the above-mentioned and other problems.

Another object of the embodiment is to provide a display device capable of implementing a high contrast ratio.

Another object of the embodiment is to provide a display device capable of implementing a high response speed for contrast ratio adjustment.

Another object of the embodiment is to provide a display device capable of implementing a transparent display in various modes.

The technical problems of the embodiment are not limited to those described in this section, but include those that can be understood through the description of the disclosure.

### [Technical Solution]

According to one aspect of the embodiment to achieve the above or other objects, a display device includes a first panel including a plurality of pixels, each including a light-emitting region and a transmission region, for a transparent display; and a second panel including a cell region corresponding to each of the plurality of pixels of the first panel for adjusting light-blocking of the first panel; in which the cell region of the second panel includes a light-blocking adjustment part, and the light-blocking adjustment part includes a first light-blocking adjustment region vertically overlapping the transmission region and including at least one first transparent electrode; a second light-blocking adjustment region horizontally contacting the first light-blocking adjustment region and vertically overlapping the light-emitting region and including at least one second transparent electrode; and light-blocking particles that are charged with a first polarity and are dispersed in a space shared between the first light-blocking adjustment region and the second light-blocking adjustment region.

A first voltage may be applied to the at least one first transparent electrode, a second voltage may be applied to the at least one second transparent electrode, the first voltage and the second voltage may be selectively applied according to a mode selected among a plurality of light-blocking adjustment modes, the plurality of light-blocking adjustment modes may include a first mode, a second mode, a third mode, a fourth mode, and a fifth mode, the first mode may be a light-blocking mode, the second mode may be a light-transmitting mode, the third mode may be a semi-light-transmitting mode, the fourth mode may be a light-transmitting variable mode, and the fifth mode may be a partial selection mode.

The first voltage may be applied to the at least one first transparent electrode in the first mode, and the first voltage may have a second polarity opposite to the first polarity.

The second voltage may be applied to the at least one second transparent electrode in the second mode, and the second voltage may have a second voltage having a second polarity opposite to the first polarity.

The first light-blocking adjustment region may include a third electrode that applies a third voltage to an inner surface of the outer part thereof.

The first voltage may be variable in the fourth mode.

The first transparent electrode may include a plurality of sub-electrodes that are horizontally spaced apart from each other, and the first voltage may be independently applied to the plurality of sub-electrodes.

The cell region of the second panel may include a pixel circuit, and at least one of the first voltage or the second voltage may be selectively applied to the light-blocking adjustment part of each of the plurality of pixels by the operation of the pixel circuit in the fifth mode.

The area of the light-blocking adjustment part may be the same as the area of the pixel, and the area of the first light-blocking adjustment region may be larger than the area of the transmission region. The area of the first transparent electrode may be larger than the area of the transmission region, and the area of the second transparent electrode may be smaller than the area of the light-emitting region.

The cell region of the second panel may include a first transparent substrate shared with the first panel; a second transparent substrate under the first transparent substrate; and the light-blocking adjustment part provided between the first transparent substrate and the second transparent substrate; and the at least one first transparent electrode may be disposed on at least one transparent substrate among the first transparent substrate or the second transparent substrate, and the at least one second transparent electrode may be disposed on at least one transparent substrate among the transparent substrate or the second transparent substrate.

The display device may further include an adhesive layer provided between the first panel and the second panel; in which the second panel may include a first transparent substrate under the adhesive layer; a second transparent substrate under the first transparent substrate; and a light-blocking adjustment part between the first transparent substrate and the second transparent substrate; the at least one first transparent electrode may be disposed on at least one transparent substrate among the first transparent substrate or the second transparent substrate, and the at least one second transparent electrode may be disposed on at least one transparent substrate among the transparent substrate or the second transparent substrate.

### [Advantageous Effect]

In the embodiment, transparent electrodes are arranged in each of the first light-blocking adjustment region and the second light-blocking adjustment region of the light-blocking adjustment part of the second panel so as to correspond to the respective transmission regions and the light-emitting region of the first panel, thereby selectively applying voltage to the transparent electrodes of each of the first light-blocking adjustment region and the second light-blocking adjustment region, thereby enabling light-blocking adjustment in various modes.

Since the area of the first light-blocking adjustment region of the second panel is larger than the area of the transmission region of the first panel, when operating in the transparent mode, the light-blocking particles are filled in the second light-blocking adjustment region having a smaller area than the area of the first light-blocking adjustment region, so that external light traveling in a diagonal direction is transmitted to the user through the first light-blocking adjustment region of the second panel and the transmission region of the first panel, so that the transmittance is maximized and the contrast ratio can be improved.

Since the area of the first light-blocking adjustment region of the second panel is larger than the area of the transmission region of the first panel, when operating in the light-blocking mode, light-blocking particles are filled in the first light-blocking adjustment region having an area larger than the area of the second light-blocking adjustment region, so that even if a user looks at the first panel in an oblique direction, the light-blocking particles on the second light-blocking adjustment region are not visible, thereby minimizing visibility.

In the light-transmitting mode, a first voltage having the same polarity as the first polarity charged to the light-blocking particles may be applied to the first transparent electrode of the first light-blocking adjustment region, and a second voltage having the second polarity opposite to the first polarity may be applied to the second transparent electrode of the second light-blocking adjustment region. Accordingly, the light-blocking particles on the first light-blocking adjustment region are pushed by the first voltage and pulled by the second voltage to fill the second light-blocking adjustment region more quickly, thereby dramatically improving the response speed of the light-blocking particles.

Similarly, in the light-blocking mode, a first voltage having a second polarity opposite to the first polarity charged to the light-blocking particles may be applied to the first transparent electrode of the first light-blocking adjustment region, and a second voltage having the same polarity as the first polarity may be applied to the second transparent electrode of the second light-blocking adjustment region. Accordingly, the light-blocking particles on the second light-blocking adjustment region are attracted by the first voltage and repelled by the second voltage to fill the first light-blocking adjustment region more quickly, thereby dramatically improving the response speed of the light-blocking particles.

By including pixel circuits in each of a plurality of cell regions of the second panel provided to correspond to each of a plurality of pixels of the first panel, the light-blocking of each of the plurality of cell regions of the second panel can be individually adjusted, thereby optimizing the light-blocking of the second panel according to the movement of the video object, thereby allowing the user to immerse themselves in the video object.

Further scope of applicability of the embodiments will become apparent from the detailed description below. However, since various changes and modifications within the spirit and scope of the embodiments will become apparent to those skilled in the art, it should be understood that the detailed description and specific embodiments, such as the preferred embodiments, are given by way of example only.

### [Description of Drawings]

FIG. 1 illustrates a conventional transparent display having a black screen.
FIG. 2 illustrates a conventional transparent display having an electrochromic layer.
FIG. 3 illustrates the operation in the light-transmitting mode of a display device according to an embodiment.
FIG. 4 illustrates the operation in the light-blocking mode of a display device according to an embodiment.
FIG. 5 illustrates the operation in semi-light-transmitting mode in a display device according to an embodiment.
FIG. 6 illustrates the operation in partial selection mode in a display device according to an embodiment.
FIG. 7 is a plan view illustrating a display device according to the first embodiment.
FIG. 8 is a cross-sectional view illustrating a display device according to the first embodiment.
FIG. 9 is a first exemplary diagram illustrating operation in the first mode in a display device according to the first embodiment.
FIG. 10 is a second exemplary diagram illustrating operation in the first mode in a display device according to the first embodiment.
FIG. 11 is a third exemplary diagram illustrating operation in the first mode in a display device according to the first embodiment.
FIG. 12 is a first exemplary diagram illustrating operation in the second mode in a display device according to the first embodiment.
FIG. 13 is a second example diagram illustrating operation in the second mode in a display device according to the first embodiment.
FIG. 14 is a second exemplary diagram illustrating the operation in the fourth mode in the display device according to the first embodiment.
FIG. 15 is a cross-sectional view illustrating a display device according to the second embodiment.
FIG. 16 is a plan view illustrating a second panel according to an embodiment.
FIG. 17 is a cross-sectional view illustrating a display device according to a third embodiment.
FIG. 18 is an exemplary diagram illustrating the operation in the first mode in a display device according to the third embodiment.
FIG. 19 is an exemplary diagram illustrating the operation in the second mode in a display device according to the third embodiment.
FIG. 20 is an exemplary diagram illustrating the operation in the third mode in a display device according to the third embodiment.
FIG. 21 is a cross-sectional view illustrating a display device according to the fourth embodiment.
FIG. 22 is a cross-sectional view illustrating a display device according to the fifth embodiment.

The size, shape, and dimensions of components depicted in the drawings may differ from the actual ones. In addition, even if the same components are depicted with different sizes, shapes, and dimensions between drawings, this is only an example in the drawings, and the same components may have the same sizes, shapes, and dimensions between drawings.

### [Best Mode]

Hereinafter, embodiments disclosed in the present specification will be described in detail with reference to the attached drawings, and regardless of the drawing symbols, identical or similar components will be given the same reference numerals and redundant descriptions thereof will be omitted. The suffixes "module" and "part" for components used in the description below are assigned or mixed in consideration of easiness in writing the specification and do not have distinctive meanings or roles by themselves. In addition, the attached drawings are intended to facilitate easy understanding of the embodiments disclosed in the present specification, and the technical ideas disclosed in the present specification are not limited by the attached drawings. In addition, when an element such as a layer, region, or substrate is mentioned as existing 'on' another component, this includes that it may be directly on the other element or that other intermediate elements may exist therebetween.

The display device described in this specification can be applied to various applications such as automobile glass, building glass, advertising billboards, cooler doors, screen doors, or the like.

In an embodiment, external light may refer to any light generated from a source other than light generated by the panel displaying the image object. For example, external light may include light provided by the sun, light provided by streetlights or other lights installed outside a home or office in the evening, light provided by lights installed on the ceiling or walls of an indoor space, or light provided by any other objects capable of generating light.

The embodiment can implement a transparent display in various modes. In other words, the embodiment can include a first mode, a second mode, a third mode, a fourth mode, and a fifth mode.

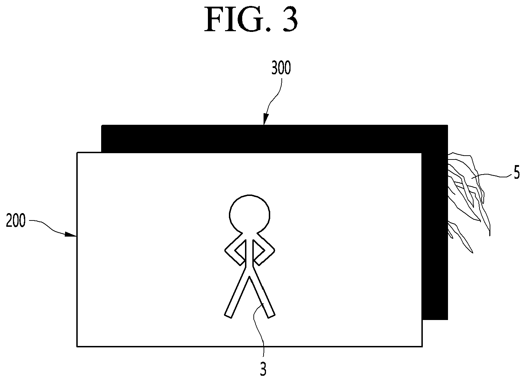

The first mode is a light-blocking mode, in which, as illustrated in FIG. 3, the second panel 300 is positioned behind the first panel 200, so that the second panel 300 can be operated in the light-blocking mode to prevent light provided behind the first panel 200, that is, external light, from transmitting through the second panel 300. In an embodiment, the light-blocking mode can be operated so that the transmittance of the second panel 300 becomes 0%. Accordingly, substantially complete black implementation is possible by blocking external light, so that a viewer (or user) positioned in front of the first panel 200 can be more immersed in viewing an image object 3 on the first panel 200. As illustrated in FIG. 3, a portion of an external object 5 that is not blocked by the second panel 300 can be visible to the viewer.

The first panel 200 may be a display panel for displaying an image, and the second panel 300 may be a panel for selectively adjusting external light provided to the first panel 200.

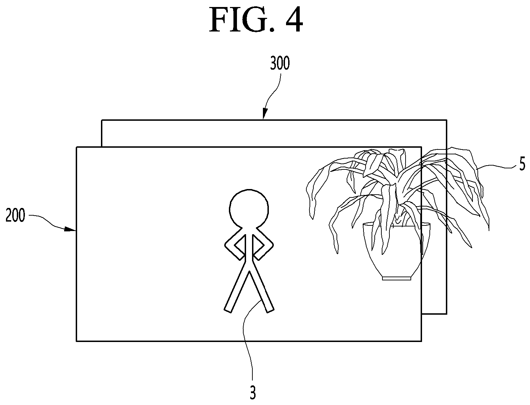

The second mode is a light-transmitting mode, in which, as illustrated in FIG. 4, the second panel 300 is positioned behind the first panel 200, so that the second panel 300 operates in the light-transmitting mode, allowing external light to pass through the second panel 300. In an embodiment, the light-transmitting mode may be operated so that the transmittance of the second panel 300 becomes 100%. Accordingly, the viewer can fully view not only the image object 3 on the first panel 200, but also the external object 5 projected behind the first panel 200.

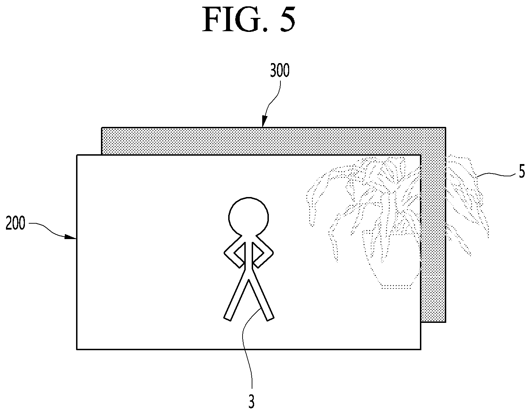

The third mode is a semi-light-transmitting mode, in which, as illustrated in FIG. 5, the second panel 300 is positioned behind the first panel 200, so that the second panel 300 operates in a semi-light-transmitting mode so that external light can selectively transmit through the second panel 300. In other words, some of the external light transmits through the second panel 300, and other parts of the external light do not transmit through the second panel 300. In an embodiment, the semi-light-transmitting mode may be operated so that the transmittance of the second panel 300 is fixed to any one of 0% to 50%. Accordingly, the viewer can view not only the image object 3 on the first panel 200 but also the external object 5 positioned behind the first panel 200 in a state of low contrast ratio, for example, dimly.

The fourth mode is a light-transmitting variable mode, in which the second panel 300 is positioned behind the first panel 200, so that the second panel 300 operates in a light-transmitting variable mode so that the amount of external light transmitted is variably selected to transmit through the second panel 300. In other words, the amount of external light transmitted through the second panel 300 can be adjusted. In an embodiment, the light-transmitting variable mode can be operated so that the transmittance of the second panel 300 is freely adjusted within a range of 0% to 100%. Accordingly, the viewer can select a contrast ratio that suits him/her, and view images corresponding to the selected contrast ratio, that is, the image object 3 and the external object 5 on the first panel 200.

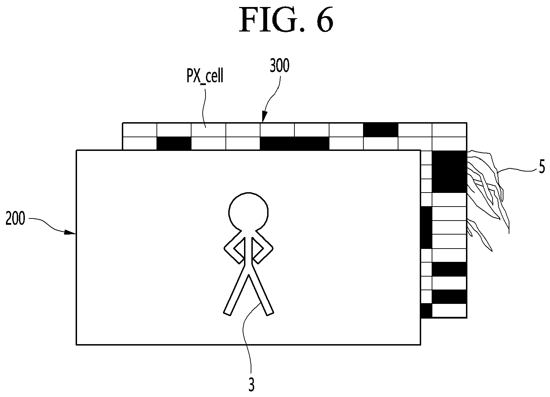

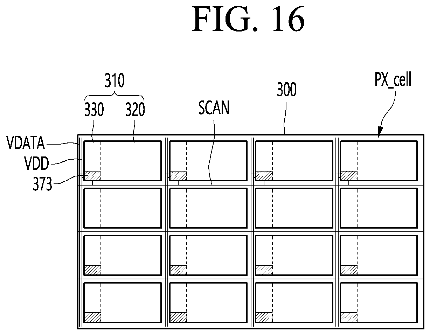

The fifth mode is a partial selection mode, in which the second panel 300 is positioned behind the first panel 200 and can be operated in the partial selection mode to individually select the transmittance of each cell region PX_cell (FIG. 6 or FIG. 16) corresponding to each of a plurality of pixels PX of the first panel 200. At this time, the transmittance of each cell region PX_Cell of the second panel 300 can be freely adjusted within 0% to 100%. The fifth mode can be applied when an image object 3 is moving and only the corresponding image object 3 being moved needs to have the transmittance of the second panel 300 set to 0%, and the remaining background objects need to have a transmittance other than 0%, for example, 50% or 100%. As the image object 3 moves, the cell region PX_Cell corresponding to the image object 3 among the cell regions PX_Cells of the second panel 300 can have its transmittance adjusted to 0%, and the cell region PX_Cell corresponding to the background object can have its transmittance adjusted to 100%. Since the image object 3 is moving, the cell areas PX_Cell of the second panel 300 must change from time to time to the cell area PX_Cell corresponding to the image object 3 and then to the cell area PX_Cell corresponding to the background object, so the transmittance of the cell areas PX_Cell of the second panel 300 must be individually adjusted. This will be described later.

Although the embodiment is described as operating in five modes, various and variable modes may be added in addition.

### [First Embodiment]

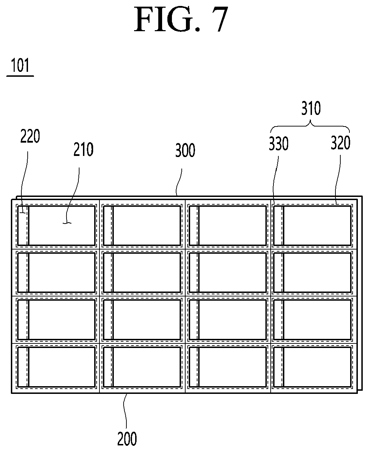

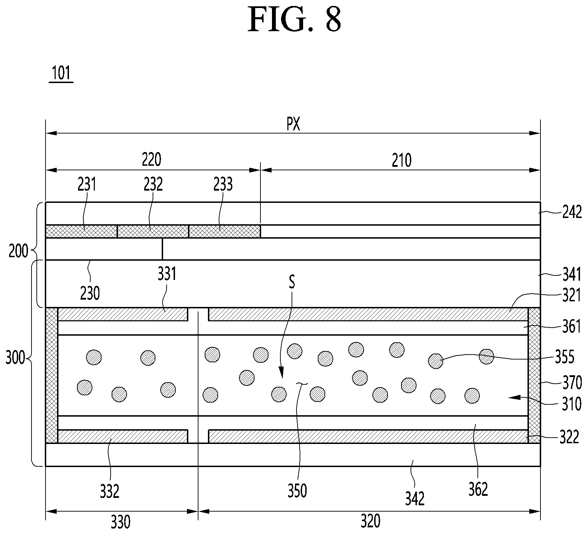

FIG. 7 is a plan view illustrating a display device according to the first embodiment. FIG. 8 is a cross-sectional view illustrating a display device according to the first embodiment.

Referring to FIGS. 7 and 8, a display device 101 according to the first embodiment is capable of implementing a transparent display and may include a first panel 200 and a second panel 300. FIG. 8 illustrates one pixel PX among a plurality of pixels of the display device 101 according to the first embodiment, and other pixels may also have the same structure as the pixel PX illustrated in FIG. 8.

The first panel 200 and the second panel 300 may be arranged in contact with each other or spaced apart from each other. With respect to the second panel 300, the first panel 200 may be positioned on the second panel 300. In this case, the user may be positioned in front of the first panel 200, and external light may be provided to the second panel 300 from behind the second panel 300.

The first panel 200 is a member for displaying an external object and may include a plurality of pixels PX. The plurality of pixels PX may be arranged in a matrix, but is not limited thereto.

Each of the plurality of pixels PX may include a light-emitting region 220 and a transmission region 210.

The light-emitting region 220 outputs color light and may include a pixel circuit 230 and a plurality of light-emitting layers 231, 232, 233. The pixel circuit 230 may control the plurality of light-emitting layers 231, 232, 233 so that each of the plurality of light-emitting layers 231, 232, 233 may output different color light. Although not illustrated, the pixel circuit 230 may include at least two transistors and one or more capacitors. The pixel circuit 230 corresponding to each of the plurality of light-emitting layers 231, 232, 233 may be individually provided, but is not limited thereto.

A plurality of light-emitting layers 231, 232, 233 are connected to the pixel circuit 230 and can output different color lights according to the control of the pixel circuit 230. The plurality of light-emitting layers 231, 232, 233 may include, for example, a red light-emitting layer that emits red light, a green light-emitting layer that emits green light, and a blue light-emitting layer that emits blue light. In an embodiment, the plurality of light-emitting layers 231, 232, 233 may be implemented using various display methods such as LCD, OLED, and micro LED.

The transmission region 210 is made of a material that allows external light to pass through. For example, when external light passes through the second panel 300 and is transmitted to the user through the transmission region 210 of the first panel 200, the user can see external objects through the recognition of the external light.

In the embodiment, the transmission region 210 is composed of various layers, and each layer can be made of a material with excellent transmittance properties. Each layer can be a conductive layer or an insulating layer.

Meanwhile, the light-emitting region 220 and the transmission region 210 may be arranged between the first transparent substrate 341 and the upper transparent substrate 242. After the light-emitting region 220 and the transmission region 210 are formed on the first transparent substrate 341, the upper transparent substrate 242 is formed on the light-emitting region 220 and the transmission region 210, thereby manufacturing the first panel 200. At this time, the first transparent substrate 341 may be a supporting substrate that supports the light-emitting region 220 and the transmission region 210, and the upper transparent substrate 242 may be a protection substrate that protects the light-emitting region 220 and the transmission region 210. Although not illustrated, a side protection member may be provided to prevent external foreign substances from penetrating or impacting in a lateral direction.

Meanwhile, as illustrated in FIG. 8, the second panel 300 may be positioned below the first panel 200 to adjust light-blocking of the first panel 200.

The second panel 300 may include a first transparent substrate 341, a light-blocking adjustment part 310, and a second transparent substrate 342. The light-blocking adjustment part 310 may be positioned under the first transparent substrate 341, and the second transparent substrate 342 may be positioned under the light-blocking adjustment part 310. Therefore, the light-blocking adjustment part 310 may be positioned between the first transparent substrate 341 and the second transparent substrate 342. The second transparent substrate 342 may be a member that supports and protects the light-blocking adjustment part 310. The first transparent substrate 341 and the second transparent substrate 342 may be made of a material having excellent transmittance.

The first transparent substrate 341 can be shared by the first panel 200 and the second panel 300. In other words, the first panel 200 can be manufactured using the first transparent substrate 341 as a base substrate, and the second panel 300 can also be manufactured. In this way, since the first transparent substrate 341 is shared by the first panel 200 and the second panel 300, there is an advantage of a thinner thickness.

The light-blocking adjustment part 310 may include a first light-blocking adjustment region 320, a second light-blocking adjustment region 330, and light-blocking particles 355. The light-blocking adjustment part 310 may be disposed in a cell region PX_Cell corresponding to each of a plurality of pixels PX of the first panel 200. In other words, the second panel 300 includes a cell region PX_Cell corresponding to each of a plurality of pixels PX, and the light-blocking adjustment part 310 may be disposed in each cell region PX_Cell. As illustrated in FIG. 8, a partition wall (or spacer, 370) may be disposed between the first transparent substrate 341 and the second transparent substrate 342 to separate the cell regions PX_Cell.

The light-blocking particles 355 are positioned in a space S shared between the first light-blocking adjustment region 320 and the second light-blocking adjustment region 330, and may be gathered in the first light-blocking adjustment region 320 or the second light-blocking adjustment region 330 or dispersed in the space S shared between the first light-blocking region and the second light-blocking adjustment region 330 according to an electrical signal. The space S may be formed by the first transparent substrate 341, the second transparent substrate 342, and the partition wall 370.

The light-blocking particles 355 may each be formed in a capsule shape. The light-blocking particles 355 may each be dispersed within a shell in which black pigment particles and conductive materials are mixed with resin. At this time, the black pigment particles and/or conductive materials may be charged with a specific polarity.

The light-blocking particles 355 are charged with a specific polarity and can move toward or away from the transparent electrodes 321, 322, 331, 332 according to an electrical signal. For example, when the light-blocking particles 355 are charged with a (-) polarity, when a voltage of a (+) polarity is applied to the transparent electrodes 321, 322, 331, 332, the light-blocking particles 355 can move toward the transparent electrodes 321, 322, 331, 332. Conversely, when a voltage of (-) polarity is applied to the transparent electrodes 321, 322, 331, 332, the light-blocking particles 355 can move away from the transparent electrodes 321, 322, 331, 332. When a voltage of (+) polarity or a voltage of (-) polarity is not applied to the transparent electrodes 321, 322, 331, 332, the light-blocking particles 355 are not affected by the electrical signal, and thus can move into the space S shared by the first light-blocking adjustment region 320 and the second light-blocking adjustment region 330.

The first light-blocking adjustment region 320 may vertically overlap the transmission region 210 of the first panel 200 and include at least one first transparent electrode 321, 322. The first transparent electrode 321, 322 may include a 1-1 transparent electrode 321 disposed on an inner surface of a first transparent substrate 341 and a 1-2 transparent electrode 322 disposed on an inner surface of a second transparent substrate 342.

As an example, only the 1-1 transparent electrode 321 may be placed, and the 1-2 transparent electrode 322 may be omitted. As another example, only the first-second transparent electrode 322 may be placed, and the 1-1 transparent electrode 321 may be omitted. As another example, both the 1-1 transparent electrode 321 and the 1-2 transparent electrode 322 may be placed.

The second light-blocking adjustment region 330 can be in horizontal contact with the first light-blocking adjustment region 320. In other words, since the first light-blocking adjustment region 320 and the second light-blocking adjustment region 330 are positioned on a horizontal line, the light-blocking particles 355 can move horizontally within the space S shared by the first light-blocking adjustment region 320 and the second light-blocking adjustment region 330, but this is not limited thereto.

The second light-blocking adjustment region 330 may vertically overlap the light-emitting region 220 of the first panel 200 and include at least one second transparent electrode 331, 332. The second transparent electrode 331, 332 may include a 2-1 transparent electrode 331 disposed on the inner surface of the first transparent substrate 341 and a 2-2 transparent electrode 332 disposed on the inner surface of the second transparent substrate 342.

The first transparent electrode 321, 322 and the second transparent electrode 331, 332 may be horizontally spaced apart. For example, the first transparent electrode 321, 322 and the second transparent electrode 331, 332 may be arranged on the inner surface of the first transparent substrate 341. For example, the first transparent electrode 321, 322 and the second transparent electrode 331, 332 may be arranged on the inner surface of the second transparent substrate 342.

The first transparent electrode 321, 322 and the second transparent electrode 331, 332 may be made of a transparent conductive material capable of transmitting light. For example, the first transparent electrode 321, 322 and the second transparent electrode 331, 332 may be made of a transparent conductive material such as ITO or IZO.

As an example, only the 2-1 transparent electrode 331 may be placed, and the 2-2 transparent electrode 332 may be omitted. As another example, only the 2-2 transparent electrode 332 may be placed, and the 2-1 transparent electrode 331 may be omitted. As another example, both the 2-1 transparent electrode 331 and the 2-2 transparent electrode 332 may be placed.

The 1-1 transparent electrode 321 and the 2-1 transparent electrode 331 may be arranged on the same surface. In other words, the 1-1 transparent electrode 321 and the 2-1 transparent electrode 331 may be arranged on the inner surface of the first transparent substrate 341. The 1-2 transparent electrode 322 and the 2-2 transparent electrode 332 may be arranged on the same surface. In other words, the 1-2 transparent electrode 322 and the 2-2 transparent electrode 332 may be arranged on the inner surface of the second transparent substrate 342.

Meanwhile, a plurality of cell regions PX_Cell of the second panel 300 may each correspond to a plurality of pixels PX of the first panel 200. The area of the first light-blocking adjustment region 320 of the light-blocking adjustment part 310 may be larger than the area of the transmission region 210 of the pixel PX.

When the area of the cell region PX_Cell is the same as the area of the second light-blocking adjustment region 330 of the pixel PX of the first panel 200, when the area of the first light-blocking adjustment region 320 increases, the area of the second light-blocking adjustment region 330 may decrease. In this case, the first transparent electrodes 321, 322 and the second transparent electrodes 331, 332 may also change in proportion to the change in the areas of the first light-blocking adjustment region 320 and the second light-blocking adjustment region 330. For example, when the area of the first light-blocking adjustment region 320 increases, the area of the first transparent electrodes 321, 322 arranged in the first light-blocking adjustment region 320 may increase. For example, if the area of the second light-blocking adjustment region 330 becomes smaller, the area of the second transparent electrode 331, 332 positioned in the second light-blocking adjustment region 330 may become smaller.

For example, the area of the first transparent electrode 321, 322 of the first light-blocking adjustment region 320 may be larger than the area of the transmission region 210 of the pixel PX. For example, the area of the second transparent electrode 331, 332 of the second light-blocking adjustment region 330 may be smaller than the area of the light-emitting region 220 of the pixel PX.

In this case, in the first mode, that is, the light-blocking mode, the light-blocking particles 355 fill the first light-blocking adjustment region 320 larger than the area of the transmission region 210 of the pixel PX, so that the external light traveling diagonally may be blocked by the light-blocking particles 355 of the first light-blocking adjustment region 320 and may not be transmitted to the user through the transmission region 210 of the pixel PX of the first panel 200.

In addition, in the second mode, that is, the light-transmitting mode, since the light-blocking particles 355 are filled in the second light-blocking adjustment region 330 smaller than the area of the light-emitting region 220 of the pixel PX of the first panel 200, even if the user views the first panel 200 from an oblique direction, the light-blocking particles 355 filled in the second light-blocking adjustment region 330 are not visible, thereby preventing visibility of the light-blocking particles 355. In addition, since external light traveling in an oblique direction is transmitted to the user through the second light-blocking adjustment region 330 and the transmission region 210 of the first panel 200, a higher contrast ratio can be provided.

Meanwhile, the second panel 300 may include a first insulating layer 361 disposed under the first transparent substrate 341 and a second insulating layer 362 disposed on the second transparent substrate 342.

The first insulating layer 361 may be shared by the first light-blocking adjustment region 320 and the second light-blocking adjustment region 330. The first insulating layer 361 may be arranged under the 1-1 transparent electrode 321 of the first light-blocking adjustment region 320 and the 2-1 transparent electrode 331 of the second light-blocking adjustment region 330. The first insulating layer 361 may surround the 1-1 transparent electrode 321 of the first light-blocking adjustment region 320 and the 2-1 transparent electrode 331 of the second light-blocking adjustment region 330. The first insulating layer 361 can protect the 1-1 transparent electrode 321 of the first light-blocking adjustment region 320 and the 2-1 transparent electrode 331 of the second light-blocking adjustment region 330 from the fluid 350 filled in the space S and prevent charged light-blocking particles 355 from being electrically shortcircuited with the 1-1 transparent electrode 321 of the first light-blocking adjustment region 320 and the 2-1 transparent electrode 331 of the second light-blocking adjustment region 330.

A first voltage V1 may be applied to the first transparent electrodes 321, 322, and a second voltage V2 may be applied to the second transparent electrodes 331, 332. The first voltage V1 may be applied to the 1-1 transparent electrode 321 and the 1-2 transparent electrode 322. The second voltage V2 may be applied to the 2-1 transparent electrode 331 and the 2-2 transparent electrode 332. As described above, the first voltage V1 and the second voltage V2 may not be applied or may be selectively applied according to a plurality of modes. The first voltage V1 or the second voltage V2 may be varied according to a plurality of modes. The first voltage V1 or the second voltage V2 may be varied linearly or non-linearly.

Here, "variable" may mean that the voltage having the opposite polarity to the charged polarity of the light-blocking particles 355 increases or decreases. As the potential difference between the charged polarity of the light-blocking particles 355 and the voltage having the opposite polarity increases, a stronger Coulomb force may be applied to the light-blocking particles 355.

For example, when the light-blocking particles 355 are charged with (-) polarity, the first voltage V1 or the second voltage V2 may increase or decrease as a voltage having (+) polarity. In this case, as the first voltage V1 or the second voltage V2 increases, a stronger Coulomb force acts on the light-blocking particles 355 having (-) polarity, so that the light-blocking particles 355 may move to the corresponding transparent electrodes 321, 322, 331, 332 more quickly.

For example, when the light-blocking particles 355 are charged with (+) polarity, the first voltage V1 or the second voltage V2 may increase or decrease as a voltage having (-) polarity. In this case, as the first voltage V1 or the second voltage V2 decreases, a stronger Coulomb force acts on the light-blocking particles 355 having (+) polarity, so that the light-blocking particles 355 may move to the corresponding transparent electrodes 321, 322, 331, 332 more quickly.

In the embodiment, the fluid 350 may be a liquid such as dimethylsilicone oil-based oil, DI water, or the like, but is not limited thereto. The fluid 350 may not have (+) polarity or (-) polarity so as not to impede the flow of the light-blocking particles 355.

The second insulating layer 362 may be shared by the first light-blocking adjustment region 320 and the second light-blocking adjustment region 330. The second insulating layer 362 may be disposed on the 1-2 transparent electrode 322 of the first light-blocking adjustment region 320 and the 2-2 transparent electrode 332 of the second light-blocking adjustment region 330. The second insulating layer 362 may surround the 1-2 transparent electrode 322 of the first light-blocking adjustment region 320 and the 2-2 transparent electrode 332 of the second light-blocking adjustment region 330. The second insulating layer 362 can protect the 1-2 transparent electrode 322 of the first light-blocking adjustment region 320 and the 2-2 transparent electrode 332 of the second light-blocking adjustment region 330 from the fluid 350 filled in the space S and prevent charged light-blocking particles 355 from being electrically shortcircuited with the 1-2 transparent electrode 322 of the first light-blocking adjustment region 320 and the 2-2 transparent electrode 332 of the second light-blocking adjustment region 330.

The surfaces of each of the first insulating layer 361 and the second insulating layer 362 in contact with the fluid 350 filled in the space S may have a straight plane so as not to impede the movement of the light-blocking particles 355. The first insulating layer 361 and the second insulating layer 362 may be made of a material having excellent transmittance.

Below, the operation method for various modes in the display device 101 according to the first embodiment configured as described above is described.

According to an embodiment, the first voltage V1 and the second voltage V2 can be selectively applied according to the first mode, the second mode, the third mode, the fourth mode, and the fifth mode.

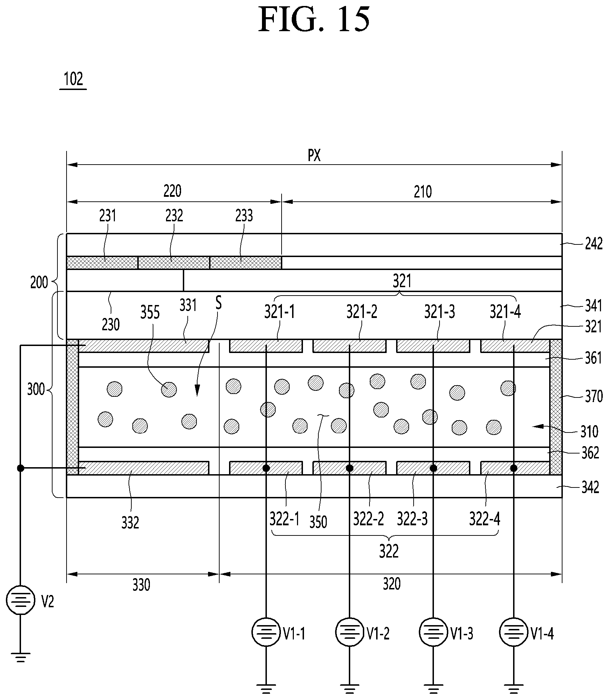

The display device according to the first embodiment 101 (FIGS. 7 and 8) can be driven in the first mode, the second mode, the third mode, and the fourth mode, and the fifth mode can be driven in the display device according to the second embodiment 102 (FIGS. 15 and 16). Accordingly, the fifth mode will be described later.

### <First Mode>

In the first mode, that is, the light-blocking mode, a first voltage V1 may be applied to the first transparent electrode 321, 322. In this case, the first voltage V1 may have a polarity (hereinafter, referred to as a second polarity) opposite to the polarity (hereinafter, referred to as a first polarity) charged to the light-blocking particles 355. For example, when the light-blocking particles 355 are charged with a (-) polarity, the first voltage V1 may be a voltage having a (+) polarity. In this case, the Coulomb force applied to the light-blocking particles 355 dispersed in the first light-blocking adjustment region 320 and the second light-blocking adjustment region 330 by the first voltage V1 causes the light-blocking particles 355 to move to the first light-blocking adjustment region 320 where the first transparent electrode 321, 322 is positioned and fill the first light-blocking adjustment region 320, thereby allowing operation in a light-blocking mode that blocks the transmission of external light.

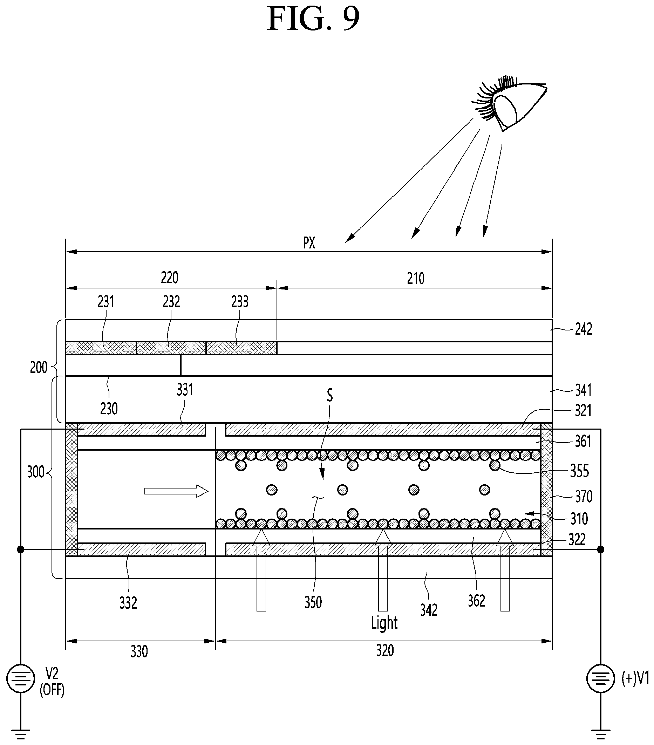

FIG. 9 is a first exemplary diagram illustrating operation in the first mode in a display device according to the first embodiment.

As illustrated in FIG. 9, when operating in the first mode, a first voltage V1 having a second polarity is applied to the first transparent electrode 321, 322, and the second transparent electrode 331, 332 is in an OFF state, so that no voltage may be applied. In this case, a Coulomb force that is attracted to the light-blocking particles 355 having the first polarity may be applied, so that the light-blocking particles 355 may move toward the first transparent electrode 321, 322. At this time, when the first voltage V1 is set to a large (+) voltage, a larger Coulomb force may be applied to the light-blocking particles 355, so that the light-blocking particles 355 may move more quickly to the first light-blocking adjustment region 320. The corresponding Coulomb force may also be applied to the light-blocking particles 355 in the space S corresponding to the second light-blocking adjustment region 330, so that the light-blocking particles 355 may also move to the first light-blocking adjustment region 320. Accordingly, the first light-blocking adjustment region 320 is filled with the light-blocking particles 355, so that external light may be blocked by the light-blocking particles 355 and may not be transmitted to the user of the voltage through the transmission region 210 of the first panel 200.

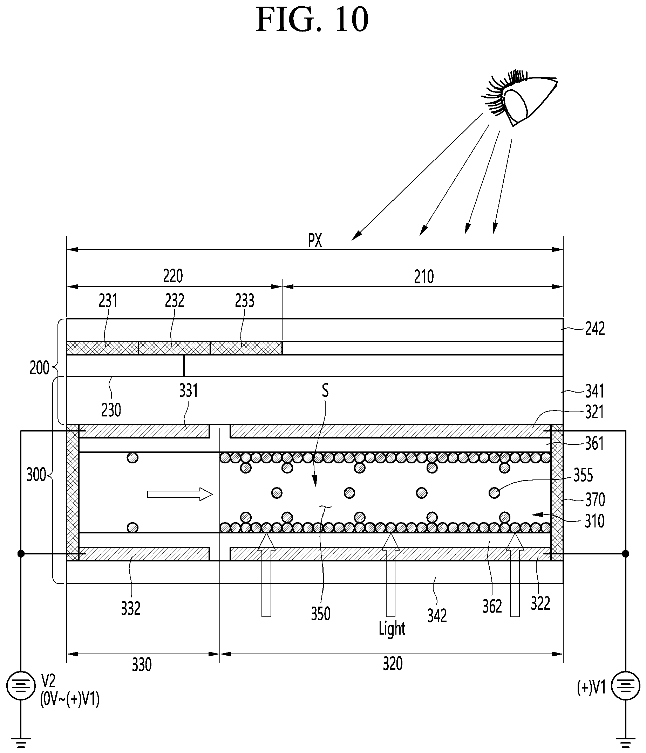

FIG. 10 is a second exemplary diagram illustrating operation in the first mode in a display device according to the first embodiment.

As illustrated in FIG. 10, when operating in the first mode, a first voltage V1 having a second polarity may be applied to the first transparent electrode 321, 322, and a second voltage V2 having a second polarity may be applied to the second transparent electrode 331, 332. At this time, the second voltage V2 may be a voltage between 0 V and the first voltage V1. For example, when the first voltage V1 is 5 V, the second voltage V2 may be 1.2 V, 3 V, 4.3 V, or the like. In other words, the second voltage V2 may be lower than the first voltage V1. Accordingly, since the first voltage V1 is greater than the second voltage V2, the Coulomb force due to the first voltage V1 acts more strongly on the light-blocking particles 355 than the second voltage V2, so that most of the light-blocking particles 355 are filled in the first light-blocking adjustment region 320, and some of the light-blocking particles 355 may be located in the second light-blocking adjustment region 330. However, since the Coulomb force due to the first voltage V1 acts more strongly on the light-blocking particles 355 than the second voltage V2, the light-blocking particles 355 located in the second light-blocking adjustment region 330 may also move to the first light-blocking adjustment region 320, but this is not limited thereto. Accordingly, the first light-blocking adjustment region 320 is filled with light-blocking particles 355, so that external light is blocked by the light-blocking particles 355 and may not not transmitted to the user of the voltage through the transmission region 210 of the first panel 200.

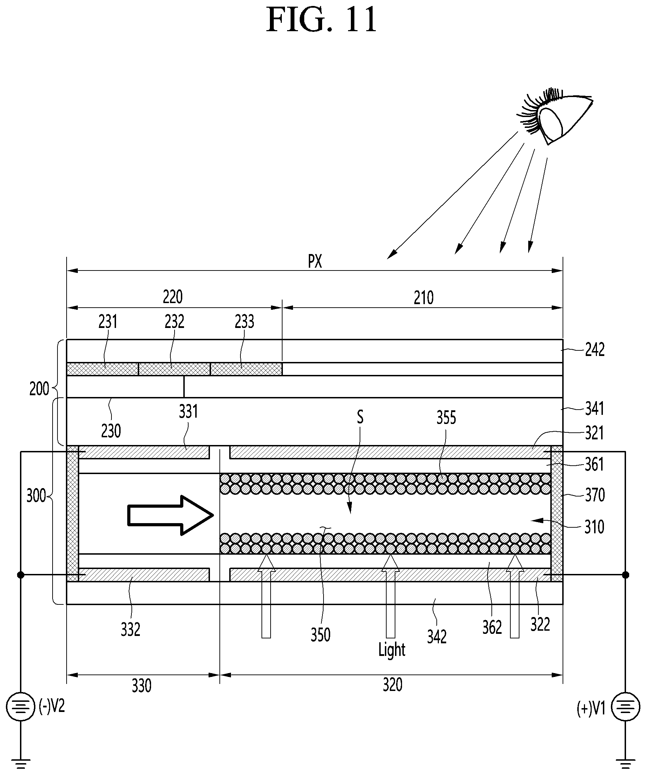

FIG. 11 is a third exemplary diagram illustrating operation in the first mode in a display device according to the first embodiment.

As illustrated in FIG. 11, when operating in the first mode, a first voltage V1 may be applied to the first transparent electrode 321, 322, and a second voltage V2 may be applied to the second transparent electrode 331, 332. The second voltage V2 may be a voltage having the same polarity as the first polarity charged to the light-blocking particles 355. Since the second voltage V2 is a voltage having the same polarity as the first polarity charged to the light-blocking particles 355, a Coulomb force repelled by the second voltage V2 may act on the light-blocking particles 355, so that the light-blocking particles 355 dispersed in the space S of the second light-blocking adjustment region 330 may quickly move away from the second transparent electrode 331, 332. In the space S of the second light-blocking adjustment region 330, the upper and lower sides are blocked by the second transparent electrodes 331, 332 and the left side is blocked by the partition wall 370, so that the light-blocking particles 355 can move to the first light-blocking adjustment region 320. Furthermore, since a Coulomb force is generated by the first voltage V1 applied to the first transparent electrode 321, 322 located in the first light-blocking adjustment region 320, the light-blocking particles 355 moving from the second light-blocking adjustment region 330 to the first light-blocking adjustment region 320 can move to the first light-blocking adjustment region 320 even more quickly. In other words, when a voltage having the same polarity as the first polarity charged to the light-blocking particles 355 is applied to the second transparent electrode 331, 332, the moving speed of the light-blocking particles 355 can be accelerated, thereby improving the operation response speed.

The first light-blocking adjustment region 320 is filled with light-blocking particles 355, so that external light is blocked by the light-blocking particles 355 and may be not transmitted to the user of the voltage through the transmission region 210 of the first panel 200. In particular, the light-blocking particles 355 are pulled by the first voltage V1 applied to the first transparent electrode 321, 322 and pushed by the second voltage V2 applied to the second transparent electrode 331, 332, so that a larger amount of light-blocking particles 355 are filled in the first light-blocking adjustment region 320 at a faster speed, so that a more perfect black, that is, 0% transmittance, can be implemented.

### <Second Mode>

In the second mode, that is, the light-transmitting mode, a second voltage V2 may be applied to the second transparent electrode 331, 332. The second voltage V2 may be a voltage having a second polarity opposite to the first polarity charged to the light-blocking particles 355. For example, when the light-blocking particles 355 are charged with a (-) polarity, the second voltage V2 may be a voltage having a (+) polarity. In this case, the Coulomb force applied to the light-blocking particles 355 dispersed in the first light-blocking adjustment region 320 and the second light-blocking adjustment region 330 by the second voltage V2 causes the light-blocking particles 355 to move to the second light-blocking adjustment region 330 where the second transparent electrodes 331, 332 are positioned, thereby filling the second light-blocking adjustment region 330 and emptying the first light-blocking adjustment region 320, thereby allowing operation in a light-transmitting mode that allows transmission of external light.

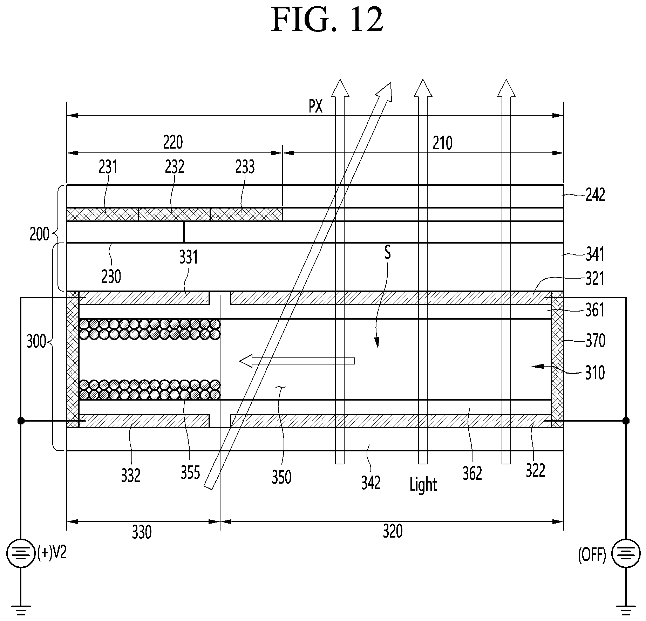

FIG. 12 is a first exemplary diagram illustrating operation in the second mode in a display device according to the first embodiment.

As illustrated in FIG. 12, when operating in the second mode, the first transparent electrodes 321, 322 are in an OFF state, no voltage is applied, and a first voltage V1 having a second polarity can be applied to the second transparent electrodes 331, 332. In this case, a Coulomb force that is attracted to the light-blocking particles 355 having the first polarity is applied, so that the light-blocking particles 355 move toward the second transparent electrode 331, 332 and can fill the second light-blocking adjustment region 330. At this time, when the second voltage V2 is set to a large (+) voltage, a larger Coulomb force is applied to the light-blocking particles 355, so that the light-blocking particles 355 can move more quickly to the second light-blocking adjustment region 330. The corresponding Coulomb force may also be applied to the light-blocking particles 355 in the space S corresponding to the first light-blocking adjustment region 320, so that the light-blocking particles 355 may also move to the second light-blocking adjustment region 330. Accordingly, the second light-blocking adjustment region 330 is filled with the light-blocking particles 355, and the first light-blocking adjustment region 320 is emptied of the light-blocking particles 355, so that external light may be transmitted to the user through the first light-blocking adjustment region 320 and the transmission region 210 of the first panel 200.

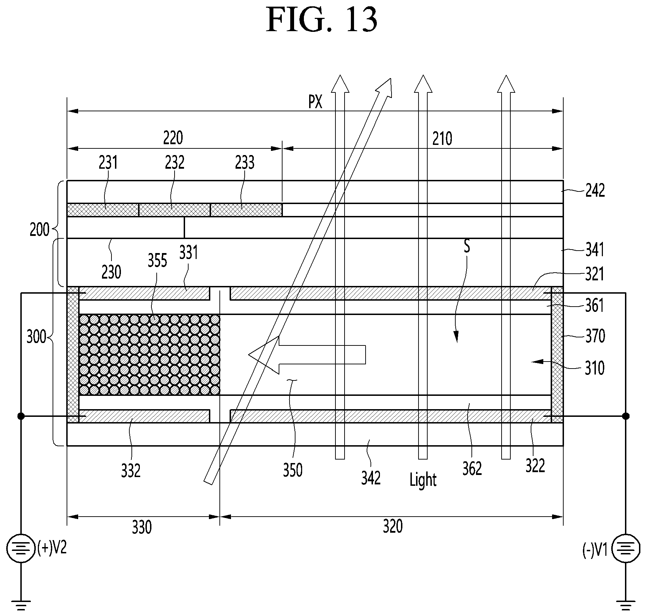

FIG. 13 is a second example diagram illustrating operation in the second mode in a display device according to the first embodiment.

As illustrated in FIG. 13, when operating in the second operation mode, a first voltage V1 may be applied to the first transparent electrode 321, 322 of the first light-blocking adjustment region 320, and a second voltage V2 may be applied to the second transparent electrode 331, 332 of the second light-blocking adjustment region 330. The first voltage V1 may be a voltage having the same polarity as the first polarity charged to the light-blocking particles 355.

Since the first voltage V1 is a voltage having the same polarity as the first polarity charged to the light-blocking particles 355, the Coulomb force repulsive to the first voltage V1 acts on the light-blocking particles 355, so that the light-blocking particles 355 dispersed in the space S of the first light-blocking adjustment region 320 can quickly move away from the first transparent electrode 321, 322. Since the space S of the first light-blocking adjustment region 320 is blocked above and below by the first transparent electrode 321, 322 and blocked on the left side by the partition wall 370, the light-blocking particles 355 can move to the second light-blocking adjustment region 330. Moreover, since a Coulomb force is generated by the second voltage V2 applied to the second transparent electrode 331, 332 located in the second light-blocking adjustment region 330, the light-blocking particles 355 moving from the first light-blocking adjustment region 320 to the second light-blocking adjustment region 330 can move to the second light-blocking adjustment region 330 even more quickly. In other words, when a voltage having the same polarity as the first polarity charged to the light-blocking particles 355 is applied to the first transparent electrode 321, 322, the moving speed of the light-blocking particles 355 can be accelerated, thereby improving the operation response speed.

The second light-blocking adjustment region 330 is filled with light-blocking particles 355 and the first light-blocking adjustment region 320 is emptied of light-blocking particles 355, so that external light can be transmitted to the user through the first light-blocking adjustment region 320 and the transmission region 210 of the first panel 200. In particular, the light-blocking particles 355 are pushed by the first voltage V1 applied to the first transparent electrode 321, 322 and pulled by the second voltage V2 applied to the second transparent electrode 331, 332, so that a larger amount of light-blocking particles 355 are filled in the second light-blocking adjustment region 330 at a faster speed, so that no light-blocking particles 355 remain in the second light-blocking adjustment region 330, so that perfect white, that is, 100% transmittance, can be implemented.

### <Third Mode>

In the third mode, that is, the semi-light-transmitting mode, as illustrated in FIG. 8, both the first transparent electrode 321, 322 of the first light-blocking adjustment region 320 and the second transparent electrode 331, 332 of the second light-blocking adjustment region 330 may be in the OFF state and no voltage may be applied. In this case, no Coulomb force acts on the light-blocking particles 355 dispersed in the space S shared between the first light-blocking adjustment region 320 and the second light-blocking adjustment region 330, so that the light-blocking particles 355 may be fixed or freely moved while dispersed in the space S. Since the first light-blocking adjustment region 320 is not filled with light-blocking particles 355 to an extent that they block the transmission of light, external light may be partially transmitted to the user through the first light-blocking adjustment region 320 and the transmission region 210 of the first panel 200. The user may recognize external light with a faint contrast ratio. The transmittance at this time may be 50% or less. The transmittance may be determined in the range of 0% to 50% according to the density, size, shape, or the like of the light-blocking particles 355 dispersed in the space S.

### <Fourth Mode>

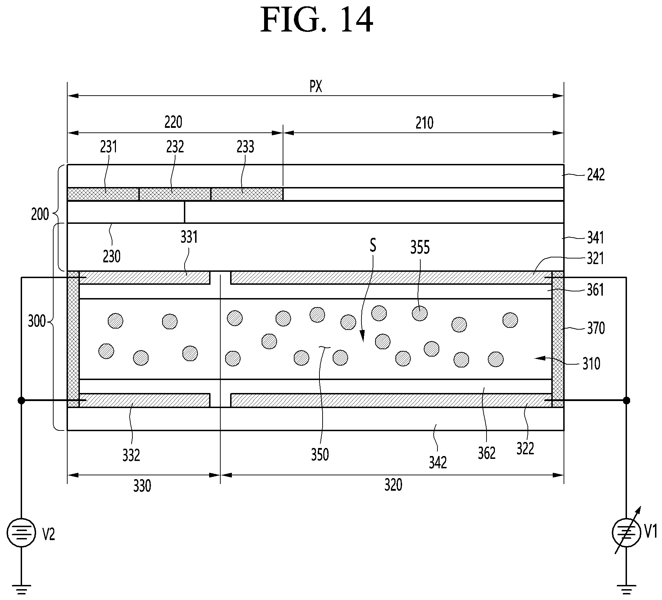

In the fourth mode, that is, the light-transmitting variable mode, as illustrated in FIG. 14, a first voltage V1 may be applied to the first transparent electrode 321, 322 of the first light-blocking adjustment region 320. The first voltage V1 may be a variable voltage. When a voltage range is set, it may be variable within the voltage range. For example, when the voltage range is set to -5 V to +5 V, the first voltage V1 may be variable from -5 V to +5 V. The first voltage V1 may be variable to increase from -5 V to +5 V or to decrease from +5 V to -5 V.

For example, when the light-blocking particles 355 are charged with a (-) polarity, when the first voltage V1 is reduced to a voltage having a (-) polarity with respect to 0 V, the Coulomb force pushing against the light-blocking particles 355 increases, so that the light-blocking particles 355 in the first light-blocking adjustment region 320 can move more quickly and in greater numbers to the second light-blocking adjustment region 330. Accordingly, the amount of external light transmitting through the first light-blocking adjustment region 320 increases, so that the transmittance increases, and brighter external light can be transmitted to the user.

For example, when the first voltage V1 is increased to a voltage having a (+) polarity with respect to 0 V, the Coulomb force attracted to the light-blocking particles 355 increases, so that the light-blocking particles 355 of the second light-blocking adjustment region 330 can move more quickly and in greater numbers to the first light-blocking adjustment region 320. Accordingly, the amount of external light transmitting through the first light-blocking adjustment region 320 is reduced, so that the transmittance is reduced, and thus even darker external light can be transmitted to the user.

Meanwhile, a second voltage V2 may be applied to the second transparent electrode 331, 332 of the second light-blocking adjustment region 330 or may be maintained in an OFF state. The second voltage V2 may vary according to the polarity of the voltage applied to the first transparent electrode 321, 322 of the first light-blocking adjustment region 320. For example, when the first voltage V1 increases to a voltage having a (+) polarity, the second voltage V2 may be a voltage having a (-) polarity. For example, when the first voltage V1 decreases to a voltage having a (-) polarity, the second voltage V2 may be a voltage having a (+) polarity.

### [Second Embodiment]

FIG. 15 is a cross-sectional view illustrating a display device according to the second embodiment.

The second embodiment is identical to the first embodiment except that the first transparent electrode 321, 322 includes a plurality of sub-electrodes 321-1 to 321-4, 322-1 to 322-4. In the second embodiment, components having the same shape, structure, and/or function as those in the first embodiment are given the same drawing symbols and a detailed description is omitted.

Referring to FIG. 15, a display device 102 according to the second embodiment is capable of implementing a transparent display and may include a first panel 200 and a second panel 300. FIG. 15 illustrates one pixel PX among a plurality of pixels of the display device (102) according to the second embodiment, and other pixels may also have the same structure as the pixel PX illustrated in FIG. 15.

The second panel 300 includes a light-blocking adjustment part 310, and the light-blocking adjustment part 310 may include a first region, a second light-blocking adjustment region 330, and light-blocking particles 355.

The first light-blocking adjustment region 320 may include at least one first transparent electrode 321, 322, and the second light-blocking adjustment region 330 may include at least one second transparent electrode 331, 332.

In the second embodiment, the first transparent electrode 321, 322 may include a 1-1 transparent electrode 321 and a 1-2 transparent electrode 322. In this case, the 1-1 transparent electrode 321 may include a plurality of sub-electrodes 321-1 to 321-4, and the 1-2 transparent electrode 322 may include a plurality of sub-electrodes 322-1 to 322-4.

These plurality of sub-electrodes 321-1 to 321-4, 322-1 to 322-4 can be horizontally spaced apart. The plurality of sub-electrodes 321-1 to 321-4, 322-1 to 322-4 can each be independently applied with a first voltage V1-1 to V1-4. The first voltage V1-1 to V1-4 can be a voltage having a (-) polarity, 0 V, or a voltage having a (+) polarity. For example, the first voltages V1-1 to V1-4 applied to each of the plurality of sub-electrodes 321-1 to 321-4, 322-1 to 322-4 can be the same or different. A first voltage V1-1 to V1-4 that becomes larger as it goes from left to right may be applied to the plurality of sub-electrodes 321-1 to 321-4, 322-1 to 322-4. For example, a first voltage V1-1 to V1-4 of 1 V, 2 V, 3 V, and 5 V may be applied to each of the first sub-electrode 321-1, the second sub-electrode 321-2, the third sub-electrode 321-3, and the fourth sub-electrode 321-4, but this is not limited thereto. Conversely, a first voltage V1-1 to V1-4 that becomes larger as it goes from right to left may be applied to the plurality of sub-electrodes 321-1 to 321-4, 322-1 to 322-4.

According to the second embodiment, by applying different first voltages V1-1 to V1-4 to each of the plurality of sub-electrodes 321-1 to 321-4, 322-1 to 322-4, the number of light-blocking particles filled in the space S corresponding to each of the plurality of sub-electrodes 321-1 to 321-4, 322-1 to 322-4 among the corresponding spaces S can be changed. Accordingly, since the transmittance of each of the regions corresponding to each of the plurality of sub-electrodes 321-1 to 321-4, 322-1 to 322-4 among the first light-blocking adjustment region 320 is changed, the transmittance of the first light-blocking adjustment region 320 can be controlled more finely.

According to the second embodiment, by applying different first voltages V1-1 to V1-4 to each of the plurality of sub-electrodes 321-1 to 321-4, 322-1 to 322-4, the transmittance of the second panel 300 can be adjusted according to the ambient illuminance to provide an appropriate contrast ratio to the first panel 200, thereby improving the user's visibility. For example, when the user's eyes are dazzled by the ambient illuminance, for example, strong sunlight, and the visibility of the first panel 200 is reduced, the transmittance of the first light-blocking adjustment region 320 of the second panel 300 can be lowered. Accordingly, the amount of sunlight that passes through the first light-blocking adjustment region 320 of the second panel 300 is reduced, thereby improving the user's visibility of the first panel 200, and the user can better recognize the image object on the first panel 200.

Meanwhile, FIG. 16 is a plan view illustrating a second panel according to an embodiment. The fifth mode can be operated using the second panel 300 illustrated in FIG. 16.

As illustrated in FIG. 16, the second panel 300 may include a first light-blocking adjustment region 320, a second light-blocking adjustment region 330, and a pixel circuit 373. The first light-blocking adjustment region 320, the second light-blocking adjustment region 330, and the pixel circuit 373 may be arranged in a cell region PX_Cell corresponding to each of a plurality of pixels PX of the first panel 200. In other words, the second panel 300 may include a plurality of cell regions PX_Cell, and the plurality of cell regions PX_Cell may each correspond to a plurality of pixels PX of the first panel 200.

The pixel circuit 373 may include at least two switches and at least two capacitors.

For example, the light-blocking of the first light-blocking adjustment region 320 can be controlled by the first switch and the first capacitor. For example, the light-blocking of the second light-blocking adjustment region 330 can be adjusted by the second switch and the second capacitor.

For example, a first switch may be connected to a first transparent electrode 321, 322 of a first light-blocking adjustment region 320, and a first voltage V1 may be selectively applied to the first transparent electrode 321, 322 according to the switching control of the first switch. For example, a second switch may be connected to a second transparent electrode 331, 332 of the second light-blocking adjustment region 330 and thus may be selectively applied to the second transparent electrode 331, 332 according to the switching control of the second switch.

A plurality of scan lines SCAN, a plurality of data lines VDATA, and a plurality of power lines VDD can be connected to the pixel circuit 373 of each of a plurality of cell regions PX_Cell of the second panel 300.

In the fifth mode, that is, the partial selection mode, the first voltage V1 and/or the second voltage V2 are selectively applied individually to the plurality of cell regions PX_Cells, so that the plurality of cell regions PX_Cells can be light-blocking, light-transmitting, semi-light-transmitting, or variably light-blocking.

According to the second embodiment, by including a pixel circuit 373 in each of a plurality of cell regions PX_Cell of the second panel 300 that are provided to correspond to each of a plurality of pixels PX of the first panel 200, the light-blocking of each of the plurality of cell regions PX_Cell of the second panel 300 is individually adjusted, thereby optimizing the light-blocking of the second panel 300 according to the movement of the video object, thereby allowing the user to immerse themselves in the video object.

### [Third Embodiment]

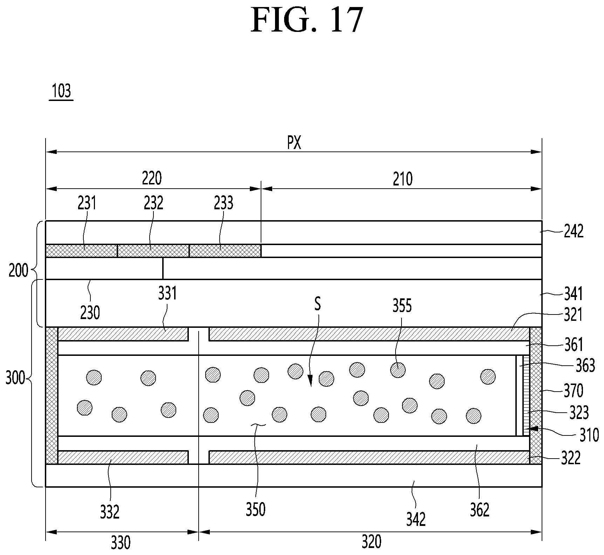

FIG. 17 is a cross-sectional view illustrating a display device according to a third embodiment.

The third embodiment is identical to the first embodiment or the second embodiment except for the third electrode 323 and the third insulating layer 363. In the third embodiment, components having the same shape, structure, and/or function as those in the first embodiment or the second embodiment are given the same drawing symbols and detailed descriptions are omitted.

Referring to FIG. 17, a display device 103 according to a third embodiment is capable of implementing a transparent display and may include a first panel 200 and a second panel 300. FIG. 17 illustrates one pixel PX among a plurality of pixels of the display device 103 according to the third embodiment, and other pixels may also have the same structure as the pixel PX illustrated in FIG. 17.

The second panel 300 includes a light-blocking adjustment part 310, and the light-blocking adjustment part may include a first light-blocking adjustment region 320, a second light-blocking adjustment region 330, and light-blocking particles 355.

The first light-blocking adjustment region 320 may include at least one first transparent electrode 321, 322, and the second light-blocking adjustment region 330 may include at least one second transparent electrode 331, 332.

In a third embodiment, the first light-blocking adjustment region 320 may include a third electrode 323 capable of applying a third voltage V3. The third electrode 323 may be disposed on an inner surface of the partition wall 370. In addition, the first light-blocking adjustment region 320 may include a third insulating layer 363 on the third electrode 323. The third insulating layer 363 may be made of the same material as the first insulating layer 361 and/or the second insulating layer 362, but is not limited thereto.

In the first light-blocking adjustment region 320, the third electrode 323 can be operated together with the first transparent electrode 321, 322, but is not limited thereto. For example, when the first voltage V1 is applied to the first transparent electrode 321, 322, the third voltage V3 can be applied to the third electrode 323. For example, after the third voltage V3 is applied to the first transparent electrode 321, 322, the first voltage V1 can be applied to the first transparent electrode 321, 322. For example, after the first voltage V1 is applied to the first transparent electrode 321, 322, the third voltage V3 can be applied to the third electrode 323. The third electrode 323 can be made of a transparent conductive material such as ITO, but is not limited thereto. The third electrode 323 may be made of an opaque metal.

The third embodiment can be operated in the first mode, the second mode, and the third mode.

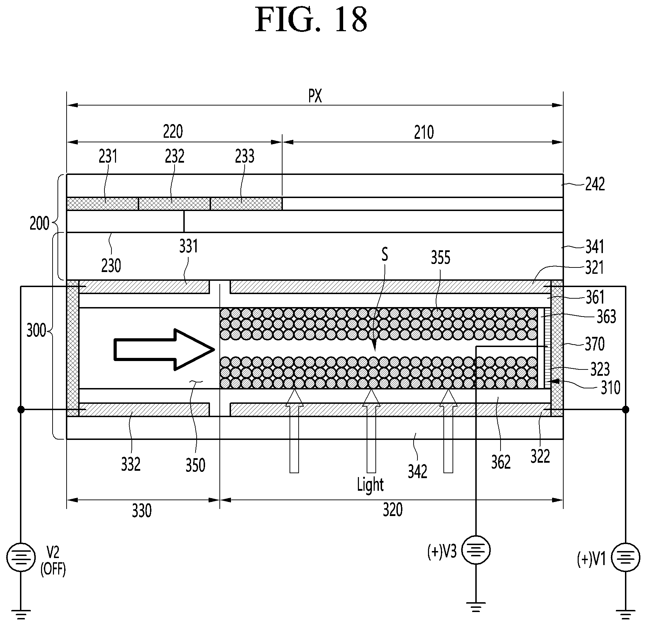

FIG. 18 is an exemplary diagram illustrating the operation in the first mode in a display device according to the third embodiment.

As illustrated in FIG. 18, in the first mode, that is, the light-blocking mode, a first voltage V1 may be applied to the first transparent electrode 321, 322, and a third voltage V3 may be applied to the third electrode 323. The first voltage V1 and the third voltage V3 may be voltages having a second polarity opposite to the first polarity charged to the light-blocking particles 355. The third voltage V3 may be a voltage having the same level as the first voltage V1, but may also be a voltage having a level greater than or less than the level of the first voltage V1.

The Coulomb force, which is more strongly pulled by the first voltage V1 and the third voltage V3, acts on the light-blocking particles 355, so that the light-blocking particles 355 on the second light-blocking adjustment region 330 quickly move to and fill the first light-blocking adjustment region 320, so that external light can be blocked by the light-blocking particles 355 filled in the first light-blocking adjustment region 320 and not transmitted to the user through the transmission region 210 of the first panel 200. Since the light-blocking particles 355 on the second light-blocking adjustment region 330 move more quickly to the first light-blocking adjustment region 320 not only by the first voltage V1 but also by the third voltage V3, the operation response speed of the first mode can be improved.

Meanwhile, when the first voltage V1 and the third voltage V3 are applied to the first transparent electrode 321, 322 and the third electrode 323, respectively, the second transparent electrode 331, 332 of the second light-blocking adjustment region 330 may be in an OFF state and no voltage may be applied, but this is not limited thereto.

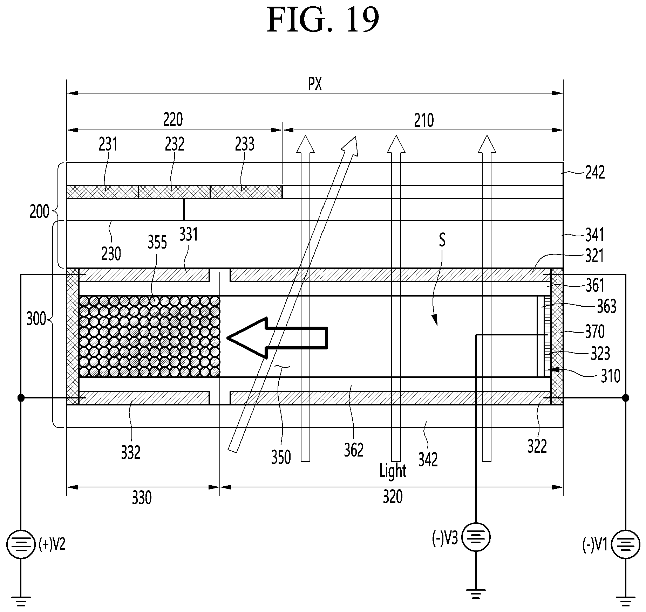

FIG. 19 is an exemplary diagram illustrating the operation in the second mode in a display device according to the third embodiment.

As illustrated in FIG. 19, in the second mode, that is, the light-transmitting mode, a first voltage V1 may be applied to the first transparent electrode 321, 322, and a third voltage V3 may be applied to the third electrode 323. The first voltage V1 and the third voltage V3 may be voltages having the same polarity as the first polarity charged to the light-blocking particles 355. The third voltage V3 may be a voltage having the same level as the first voltage V1, but may also be a voltage having a level greater than or less than the level of the first voltage V1.

The Coulomb force, which is more strongly pushed by the first voltage V1 and the third voltage V3, acts on the light-blocking particles 355, so that the light-blocking particles 355 on the first light-blocking adjustment region 320 can quickly move to and fill the second light-blocking adjustment region 330. Accordingly, no light-blocking particles 355 remain in the first light-blocking adjustment region 320, so that external light can be transmitted to the user through the first light-blocking adjustment region 320 and the transmission region 210 of the first panel 200. Since the light-blocking particles 355 on the second light-blocking adjustment region 330 move to the second light-blocking adjustment region 330 more quickly by the third voltage V3 as well as the first voltage V1, the operation response speed of the second mode can be improved.

Meanwhile, when the first voltage V1 and the third voltage V3 are applied to the first transparent electrodes 321, 322 and the third electrode 323, respectively, a voltage having a second polarity opposite to the first polarity charged to the light-blocking particles 355 may be applied as the second voltage V2 to the second transparent electrodes 331, 332 of the second light-blocking adjustment region 330. In this case, the light-blocking particles 355 on the first light-blocking adjustment region 320 are attracted by the second voltage V2 and pushed by the first voltage V1 and the third voltage V3 to fill the second light-blocking adjustment region 330 more quickly, so that the response speed of the second mode can be further improved.

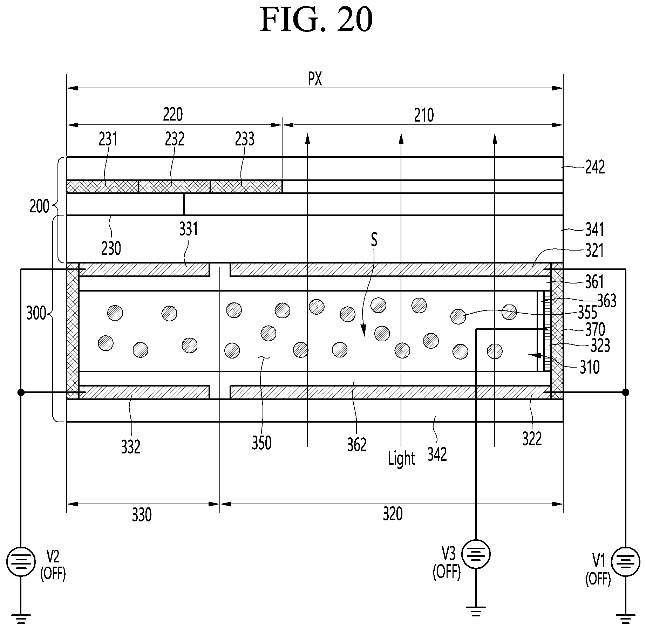

FIG. 20 is an exemplary diagram illustrating the operation in the third mode in a display device according to the third embodiment.

As illustrated in FIG. 20, in the third mode, that is, the semi- transmission mode, a first voltage V1 and a second voltage V2 may be applied to the first transparent electrodes 321, 322 and the third electrode 323 of the first light-blocking adjustment region 320, respectively, and a third voltage V3 may be applied to the second transparent electrodes 331, 332 of the second light-blocking adjustment region 330. At this time, the first voltage V1, the second voltage V2, and the third voltage V3 may all be in the OFF state, and no voltage may be applied. In this case, the Coulomb force does not act on the light-blocking particles 355 of the light-blocking adjustment part 310, that is, the first light-blocking adjustment region 320 and the second light-blocking adjustment region 330, so that the light-blocking particles 355 may be fixed in their previously distributed positions or may move freely.

Since the first light-blocking adjustment region 320 is not densely filled with light-blocking particles 355, external light can be selectively transmitted. Accordingly, since the external light has a transmittance of 50% or less and is transmitted to the user through the transmission region 210 of the first panel 200, the user can recognize the external light with a dim contrast ratio. According to the density, size, shape, or the like of the light-blocking particles 355 dispersed in the space S, the transmittance can be determined in the range of 0% to 50%.

### [Fourth Embodiment]

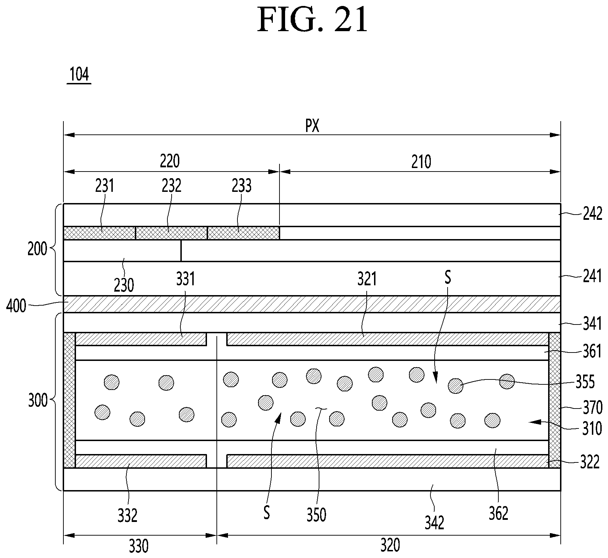

FIG. 21 is a cross-sectional view illustrating a display device according to the fourth embodiment.

The fourth embodiment is the same as the first to third embodiments except that the first panel 200 and the second panel 300 are bonded using an adhesive layer 400. In the fourth embodiment, components having the same shape, structure, and/or function as those in the first to third embodiments are given the same drawing symbols and detailed descriptions are omitted.

Referring to FIG. 21, a display device 104 according to the fourth embodiment is capable of implementing a transparent display and may include a first panel 200, a second panel 300, and an adhesive layer 400. FIG. 21 illustrates one pixel PX among a plurality of pixels of the display device 104 according to the fourth embodiment, and other pixels may also have the same structure as the pixel PX illustrated in FIG. 21.

The first panel 200 and the second panel 300 can be bonded to each other via an adhesive layer 400.

The first panel 200 may include a lower transparent substrate 241, a light-emitting region 220, a transmission region 210, and an upper transparent substrate 242. The light-emitting region 220 and the transmission region 210 may be positioned between the lower transparent substrate 241 and the upper transparent substrate 242. The light-emitting region 220 and the transmission region 210 are formed on the lower transparent substrate 241 through a series of processes, and the upper transparent substrate 242 is formed on the light-emitting region 220 and the transmission region 210, thereby manufacturing the first panel 200.

The second panel 300 may include a first transparent substrate 341, a light-blocking adjustment part 310, and a second transparent substrate 342. The light-blocking adjustment part 310 may be placed between the first transparent substrate 341 and the second transparent substrate 342. The light-blocking adjustment part 310 may be formed on the first transparent substrate 341 through a series of processes, and the second transparent substrate 342 may be formed on the light-blocking adjustment part 310, thereby manufacturing the second panel 300.

Thereafter, the lower transparent substrate 241 of the first panel 200 and the first transparent substrate 341 of the second panel 300 are bonded via the adhesive layer 400, thereby manufacturing a display device 104 according to the fourth embodiment.

Since the light-emitting region 220 and the transmission region 210 of the first panel 200 and the transmission adjustment part of the second panel 300 have been described above, further description is omitted.

### [Fifth Embodiment]

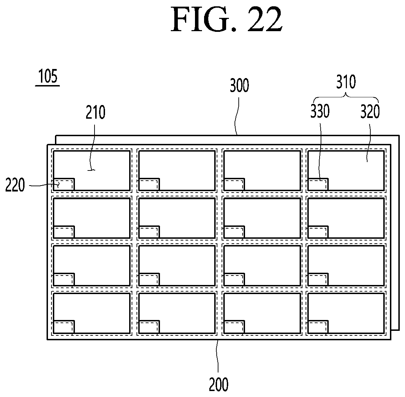

FIG. 22 is a cross-sectional view illustrating a display device according to the fifth embodiment.

The fifth embodiment is identical to the first to fourth embodiments except for the shapes of the light-emitting region 220 and the transmission region 210 of the first panel 200 and the first light-blocking adjustment region 320 and the second light-blocking adjustment region 330 of the second panel 300. In the fifth embodiment, components having the same shape, structure, and/or function as those of the first to fourth embodiments are given the same drawing symbols and a detailed description thereof is omitted.

Referring to FIG. 22, a display device 105 according to the fifth embodiment is capable of implementing a transparent display and may include a first panel 200 and a second panel 300. A display device 105 according to the fifth embodiment is capable of implementing a transparent display and may include a first panel 200, a second panel 300, and an adhesive layer 400. FIG. 22 illustrates one pixel PX among a plurality of pixels of a display device according to the fifth embodiment, and other pixels may also have the same structure as the pixel PX illustrated in FIG. 22.

The first panel 200 may include a plurality of pixels PX, and each of the plurality of pixels PX may include a light-emitting region 220 and a transmission region 210. For example, the transmission region 210 may have a larger region than the light-emitting region 220 and may have a "_{¬}" shape. In other words, the transmission region 210 may surround the right and upper sides of the light-emitting region 220. For example, the area of the transmission region 210 may be 1.5 times or more the area of the light-emitting region 220.

The second panel 300 includes a cell region PX_Cell corresponding to each of a plurality of pixels PX of the first panel 200, and the cell region PX_Cell may include a light-blocking adjustment part 310. The light-blocking adjustment part 310 may include a first light-blocking adjustment region 320 and a second light-blocking adjustment region 330. The first light-blocking adjustment region 320 may have a shape corresponding to the shape of the light-emitting region 220 of the first panel 200, and the second light-blocking adjustment region 330 may have a shape corresponding to the shape of the transmission region 210 of the first panel 200. For example, the first light-blocking adjustment region 320 may have an area larger than that of the first light-blocking adjustment region 320 and may have a " 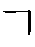 " shape. In other words, the first light-blocking adjustment region 320 can surround the right and upper sides of the second light-blocking adjustment region 330. For example, the area of the first light-blocking adjustment region 320 can be 1.5 times or more that of the second light-blocking adjustment region 330. Meanwhile, the area of the first light-blocking adjustment region 320 can be larger than the area of the transmission region 210 of the first panel 200, and the area of the second light-blocking adjustment region 330 can be smaller than the area of the light-emitting region 220 of the first panel 200.

According to the fifth embodiment, the area of the transmission region 210 is 1.5 times or more the area of the light-emitting region 220, and the area of the first light-blocking adjustment region 320 is 1.5 times or more the area of the second light-blocking adjustment region 330, so that the amount of external light passing through the first light-blocking adjustment region 320 of the second panel 300 and the transmission region 210 of the first panel 200 is maximized, thereby further increasing the transmittance and improving the contrast ratio.

The above detailed description should not be construed as restrictive in all respects but should be considered as illustrative. The scope of the embodiments should be determined by a reasonable interpretation of the appended claims, and any changes that come within the equivalent scope of the embodiment are included within the scope of the embodiment.

### [Industrial Applicability]

The embodiment can be adopted in the field of displays that display images or information. The embodiment can be applied to various applications such as automobile glass, building glass, advertising billboards, cooler doors, screen doors, or the like.

## Claims

1. A display device comprising:
a first panel including a plurality of pixels, each including a light-emitting region and a transmission region, for a transparent display; and
a second panel including a cell region corresponding to each of the plurality of pixels of the first panel for adjusting light-blocking of the first panel;
wherein the cell region of the second panel includes a light-blocking adjustment part, and
wherein the light-blocking adjustment part includes:
a first light-blocking adjustment region vertically overlapping the transmission region and including at least one first transparent electrode;
a second light-blocking adjustment region horizontally contacting the first light-blocking adjustment region and vertically overlapping the light-emitting region and including at least one second transparent electrode; and
light-blocking particles that are charged with a first polarity and are dispersed in a space shared between the first light-blocking adjustment region and the second light-blocking adjustment region.

2. The display device of claim 1,
wherein a first voltage is applied to the at least one first transparent electrode,
wherein a second voltage is applied to the at least one second transparent electrode,
wherein the first voltage and the second voltage are selectively applied according to a mode selected among a plurality of light-blocking adjustment modes,
wherein the plurality of light-blocking adjustment modes include a first mode, a second mode, a third mode, a fourth mode, and a fifth mode,
wherein the first mode is a light-blocking mode,
wherein the second mode is a light-transmitting mode,
wherein the third mode is a semi-light-transmitting mode,
wherein the fourth mode is a light-transmitting variable mode, and
wherein the fifth mode is a partial selection mode.

3. The display device of claim 2,
wherein the first voltage is applied to the at least one first transparent electrode in the first mode, and
wherein the first voltage has a second polarity opposite to the first polarity.

4. The display device of claim 3,
wherein the second voltage is applied to the at least one second transparent electrode in the first mode, and
wherein the second voltage is a voltage between 0 V and the first voltage.

5. The display device of claim 3,
wherein the second voltage is applied to the at least one second transparent electrode in the first mode, and
wherein the second voltage is a voltage having the same polarity as the first polarity.

6. The display device of claim 2,
wherein the second voltage is applied to the at least one second transparent electrode in the second mode, and
wherein the second voltage has a second voltage having a second polarity opposite to the first polarity.

7. The display device of claim 6,
wherein the first voltage is applied to the at least one first transparent electrode in the second mode, and
wherein the first voltage is a voltage having the same polarity as the first polarity.

8. The display device of claim 2,
wherein the first light-blocking adjustment region includes a third electrode that applies a third voltage to an inner surface of the outer part thereof.

9. The display device of claim 8,
wherein the third voltage in the first mode is a voltage having the same polarity as the second polarity.

10. The display device of claim 8,
wherein the third voltage in the second mode is a voltage having the same polarity as the first polarity.

11. The display device of claim 8,
wherein the first voltage, the second voltage, and the third voltage are each 0V in the third mode.

12. The display device of claim 2,
wherein the first voltage is variable in the fourth mode.

13. The display device of claim 2,
wherein the first transparent electrode includes a plurality of sub-electrodes that are horizontally spaced apart from each other, and
wherein the first voltage is independently applied to the plurality of sub-electrodes.

14. The display device of claim 2,
wherein the cell region of the second panel includes a pixel circuit, and wherein at least one of the first voltage or the second voltage is selectively applied to the light-blocking adjustment part of each of the plurality of pixels by the operation of the pixel circuit in the fifth mode.

15. The display device of claim 1,
wherein the first transparent electrode and the second transparent electrode are horizontally spaced apart.

16. The display device of claim 1,
wherein the area of the light-blocking adjustment part is the same as the area of the pixel, and
wherein the area of the first light-blocking adjustment region is larger than the area of the transmission region.

17. The display device of claim 16,
wherein the area of the first transparent electrode is larger than the area of the transmission region, and
wherein the area of the second transparent electrode is smaller than the area of the light-emitting region.

18. The display device of claim 1,
wherein the cell region of the second panel comprises:
a first transparent substrate shared with the first panel;
a second transparent substrate under the first transparent substrate; and
the light-blocking adjustment part provided between the first transparent substrate and the second transparent substrate; and
wherein the at least one first transparent electrode is disposed on at least one transparent substrate among the first transparent substrate or the second transparent substrate, and
wherein the at least one second transparent electrode is disposed on at least one transparent substrate among the transparent substrate or the second transparent substrate.

19. The display device of claim 1, further comprising:
an adhesive layer provided between the first panel and the second panel;
wherein the second panel includes:
a first transparent substrate under the adhesive layer;
a second transparent substrate under the first transparent substrate; and
a light-blocking adjustment part between the first transparent substrate and the second transparent substrate;
wherein the at least one first transparent electrode is disposed on at least one transparent substrate among the first transparent substrate or the second transparent substrate, and
wherein the at least one second transparent electrode is disposed on at least one transparent substrate among the transparent substrate or the second transparent substrate.

20. The display device of claim 1,
wherein the light-emitting region includes a pixel circuit and a plurality of light-emitting layers connected to the pixel circuit and outputting different color lights.
